# EUROPEAN PATENT APPLICATION

(11) **EP 4 579 254 A1**
(43) Date of publication of application: **02.07.2025**
(21) Application number: 24214713.0
(22) Date of filing: 22.11.2024
(51) Int. Cl.: G01R 31/317, G06F 11/362

(54) **DESIGN FOR TEST (DFT) AND DESIGN FOR DEBUG (DFD) GATED POWER DOMAINS**

(30) Priority: 26.12.2023 US 202318395952
(71) Applicant: INTEL Corporation, Santa Clara, CA 95054 (US)
(72) Inventor: TAN, Huah Yuah, 11900 Bayan Lepas (MY); GUN, Kok Wee, 11900 Bayan Lepas (MY); KOAY, Boon Wooi, 13000 Butterworth (MY); CHIN, Kang Hui, 47650 Subang Jaya (MY); CHIAM, Kim Han, 11900 Bayan Lepas (MY)
(74) Representative: HGF

(57) **Abstract**

Power-gated domains are provided for design for test (DFT) and/or design for debug (DFX) logic units in a semiconductor chip. Power-gated domains allow power consumption to be reduced when DFT and DFD logic units are not in use. Power-gated domains can include reset features and output port power isolation.

## Description

### FIELD

Descriptions are generally related to semiconductor devices and power domains for design for test (DFT) and design for debug (DFD) features within the semiconductor device.

### BACKGROUND

Semiconductor chips are central to intelligent devices and systems, such as personal computers, laptops, tablets, phones, servers, and other consumer and industrial products and systems. Manufacturing semiconductor chips presents a number of challenges and these challenges are amplified as devices become smaller and performance demands increase. Challenges include, for example, unwanted material interactions, precision and scaling requirements, power delivery requirements, limited failure tolerance, and material and manufacturing costs.

Design for Test (DFT) and Design for Debug (DFD) logic are implemented in silicon semiconductor devices as internal hardware to achieve high volume manufacturing (HVM) yields and system debug in the field. When the DFT and DFD logic units are not implemented in a power-gated domain, the DFT and DFD logic units continually consume power and can incur leakage during non-debug platform use. The DFT and/or DFD logic (DFX logic) is not mapped into a power-gated domain, in part, because a low power state used in debug scenarios can require DFX logic to be always ON or in a more ON power domain than the logic under debug. Mapping DFX logic into a conventional power-gated domain can also add design complexity to the synthesis flow during semiconductor device development.

### BRIEF DESCRIPTION OF THE DRAWINGS

The figures are provided to aid in understanding the invention. The figures can include diagrams and illustrations of exemplary structures, assemblies, data, methods, and systems. For ease of explanation and understanding, these structures, assemblies, data, methods, and systems, the figures are not an exhaustively detailed description. The figures therefore should not be understood to depict the entire metes and bounds of structures, assemblies, data, methods, and systems possible without departing from the scope of the invention. Additionally, features are not necessarily illustrated relatively to scale due in part to the small sizes of some features and the desire for clarity of explanation in the figures.
**Figure 1** illustrates a power-gated system for a semiconductor chip design that includes power-gated domains for Design for Test and Design for Debug logic units.
**Figure 2** shows a reset qualifier useful for a power-gated domain for a Design for Test and Design for Debug logic units.
**Figure 3** shows an operational state associated with a semiconductor chip design in which power-gated domains for Design for Test and Design for Debug logic units are in an OFF state.
**Figures 4A -4B** diagram exemplary circuits for limiting functional failure during power ON and power OFF events in a power-gated domain comprising Design for Test and Design for Debug logic units.
**Figure 5** shows a timing diagram for power-gated domains for Design for Test and Design for Debug for several system modes
**Figure 6** provides a method for entering debug mode on a computing system.
**Figure 7** illustrates an exemplary circuit board.
**Figure 8** provides an exemplary computing system.

Descriptions of certain details and implementations follow, including non-limiting descriptions of the figures, which depict some examples and implementations.

### DETAILED DESCRIPTION

References to one or more examples are to be understood as describing a particular feature, structure, or characteristic included in at least one implementation of the invention. The phrases "one example" or "an example" are not necessarily all referring to the same example or embodiment. Any aspect described herein can potentially be combined with any other aspect or similar aspect described herein, regardless of whether the aspects are described with respect to the same figure or element.

The words "connected" and/or "coupled" can indicate that two or more elements are in direct physical or electrical contact with each other. The term "coupled," however, can also mean that two or more elements are not in direct contact with each other and are instead separated by one or more elements but they may still co-operate or interact with each other, for example, physically, magnetically, or electrically.

The words "first," "second," and the like, do not indicate order, quantity, or importance, but rather are used to distinguish one element from another. The words "a" and "an" herein do not indicate a limitation of quantity, but rather denote the presence of at least one of the referenced items. The terms "follow" or "after" can indicate immediately following or following some other event or events. Other sequences of operations can also be performed according to alternative embodiments. Furthermore, additional operations may be added or removed depending on the application.

Disjunctive language such as the phrase "at least one of X, Y, or Z," is used in general to indicate that an element or feature, may be either X, Y, or Z, or any combination thereof (e.g., X, Y, and/or Z). Thus, this disjunctive language should be understood not to imply that certain embodiments require at least one of X, at least one of Y, or at least one of Z to each be present.

Terms such as chip, die, IC (integrated circuit) chip, IC die, microelectronic chip, microelectronic die, semiconductor die, and/or semiconductor chip are interchangeable and refer to a semiconductor device comprising integrated circuits.

The terms "package," "packaging," "IC package," or "chip package," "microelectronics package," or "semiconductor chip package" are interchangeable and generally refer to an enclosed carrier of one or more dies, in which the dies are attached to a package substrate and encapsulated. The package substrate provides electrical interconnects between the die(s) and other dies and/or a motherboard or other printed circuit board for I/O (input/output) communication and power delivery. A package with multiple dies can, for example, be a system in a package.

A package substrate generally includes dielectric layers or structures having conductive structures on, through, and/or embedded in the dielectric layers. The dielectric layers can be, for example, build-up layers. Dielectric materials include Ajinomoto build-up film (ABF), although other dielectric materials are possible. Semiconductor package substrates can have cores or be coreless. Semiconductor packages having cores can have dielectric layers such as buildup layers on more than one side of a core, such as on two opposite sides of a core. Cores can include through-core vias that contain a conductive material. Other structures or devices are also possible within a package substrate.

A "core" or "package core" generally refers to a layer usually embedded within a package substrate. The core can provide structure or stiffness to a package substrate. A core is an optional feature of a package substrate. The core can be a dielectric organic or inorganic material and may have conductive vias extending through the layer. The conductive vias can include a metal, for example, copper. A package core can, for example, be comprised of a glass material (such as, for example, aluminosilicate, borosilicate, alumino-borosilicate, silica, and fused silica), silicon, silicon nitride, silicon carbide, gallium nitride, or aluminum oxide. In some examples, core materials are glass-fiber reinforced organic resins such as epoxy-based resins. A further example package substrate core is FR4 (woven glass fiber reinforces epoxy). In other examples, package substrate cores are solid amorphous glass materials.

Flow diagrams as illustrated herein provide examples of sequences of various process actions. The flow diagrams can indicate operations to be executed by a software or firmware routine, as well as physical operations. Physical operations can be performed by semiconductor processing equipment. Although shown in a particular sequence or order, unless otherwise specified, the order of the actions can be modified. Thus, the illustrated diagrams should be understood only as examples, and the process can be performed in a different order, and some actions can be performed in parallel. Additionally, one or more actions can be omitted and not all implementations will perform all actions.

Various components described can be a means for performing the operations or functions described. Each component described can include software, hardware, or a combination of these. Some components can be implemented as software modules, hardware modules, special-purpose hardware (for example, application specific hardware, application specific integrated circuits (ASICs), digital signal processors (DSPs), etc.), embedded controllers, or hardwired circuitry). Other components can be semiconductor testing equipment that is able to perform physical operations such as, for example, probing.

To the extent various computer operations or functions are described herein, they can be described or defined as software code, instructions, configuration, and/or data. The software content can be provided via an article of manufacture with the content stored thereon, or via a method of operating a communication interface to send data via the communication interface. A machine-readable storage medium can cause a machine to perform the functions or operations described. A machine-readable storage medium includes any mechanism that stores information in a tangible form accessible by a machine (e.g., computing device), such as recordable/non-recordable media (e.g., read only memory (ROM), random access memory (RAM), magnetic disk storage media, optical storage media, flash memory devices). Instructions can be stored on the machine-readable storage medium in a non-transitory form. A communication interface includes any mechanism that interfaces to, for example, a hardwired, wireless, or optical medium to communicate to another device, such as, for example, a memory bus interface, a processor bus interface, an Internet connection, a disk controller.

Semiconductor chip manufacturing processes are sometimes divided into front end of the line (FEOL) processes and back end of the line (BEOL) processes. Electronic circuits and active and passive devices within the chip, such as for example, transistors, capacitors, resistors, and/or memory cells, are manufactured in what can be referred to as FEOL processes. Memory cells include, for example, electronic circuits for random access memory (RAM), such as static RAM (sRAM), dynamic RAM (DRAM), read only memory (ROM), non-volatile memory, and/or flash memory. FEOL processes can be, for example, complementary metal-oxide semiconductor (CMOS) processes. BEOL processes include metallization of the chip where interconnects are formed in layers and the feature size of the interconnect increases in layers nearer the surface of the semiconductor chip. Interconnects in, for example, semiconductor chips that are integrated into heterogeneous packages (such as, for example, packages that include memory and logic chips), can also include through silicon vias (TSVs) that transverse the semiconductor chip device region. Semiconductor devices that have TSVs can blur distinctions between BEOL and FEOL processes.

Semiconductor chip interconnects can be created by forming a trench or though-layer via by etching a trench or via structure into a dielectric layer and filling the trench or via with metal. Dielectric layers can comprise, for example, low-κ dielectrics, SiO₂, silicon nitride (SiN), silicon carbide (SiC), and/or silicon carbonitride (SiCN). Low-κ dielectrics include for example, fluorine-doped SiO₂, carbon-doped SiO₂, porous SiO₂, porous carbon-doped SiO₂, combinations for the foregoing, and also these materials with airgaps. Dielectric layers that include conducting features can be intermetal dielectric (ILD) features.

Example gated power domains described herein can allow DFT and/or DFD logic that is spread across all physical design partitions of a semiconductor chip to be in a power-gated domain. Gated power domains can reduce power usage and leakage situations that can result from an always ON state. Design automations can be created to address the complexity involved in creating Unified Power Format (UPF) file, implementing power isolation, and logic verification flow.

DFT and DFD logic are typically not user-visible features. Ideally features that are not user-visible should not be consuming power directly or through leakage in a non-debug user platform. DFT and DFD logic that is implemented in a power-gated domain that can be powered down allows more power to be channeled to computing engines such as cores and graphics during operation. Additionally, removing power usage by features that are not in operation for a user can extend battery life.

A conventional power gating scheme is localized to a block of integrated circuit logic, a unit of layout design, an intellectual property core (IP), and/or is feature-specific. The power management unit (PMU) shuts off the power supply to targeted block of integrated circuit logic once the block of integrated circuit logic is in idle. In this power gating scheme, DFT and/or DFD (DFX) logic can be debug islands that require the PMU to shut off power supply to all individual DFX logic units and/or DFX IPs one by one via power management (PM) handshake.

A different power-gated domain scheme where a power domain is dedicated to all DFX networks and/or other blocks of integrated circuit logic can be implemented across all partitions for an entire semiconductor chip. This DFX power-gated domain can be turned off all at once whenever a semiconductor chip is in production mode (i.e., when Debug Mode is OFF) which can be when the device is operating for a user. Each physical design partition can have a new voltage area that can be controlled by power gates or power switches, to turn-on or turn-off the power domain.

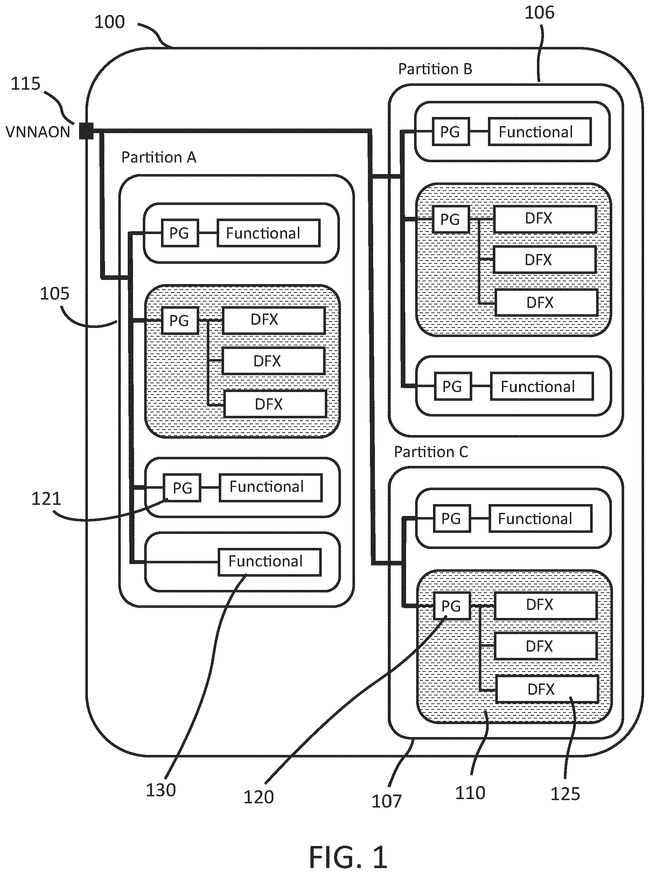

Figure 1 provides a diagram of an exemplary system design for a semiconductor chip. An actual semiconductor chip design is more complex and this one has been simplified for ease of explanation. For example, currently a semiconductor chip can have 8 to 13 partitions, or 20 to 100 partitions for a larger die. In Figure 1, a high-level diagram shows the implementation of DFX power-gated domains (INF_DFX power domains) 110 in the design partitions 105, 106, and 107 of a semiconductor chip design 100. A DFX power-gated domain can include logic units and/or IP blocks that are designed to test and/or debug functional logic units. For example DFX logic units can include Test-Access Port (TAP) logic units, Visualization of Internal Signal Architecture (VISA) logic units, and/or DFT scan logic units. DFT scan is a technique that can facilitate the testing and debugging of integrated circuits (ICs). Other types of logic units and or IP blocks are possible. Because of the advantageous voltage consumption profiles associated with the implementation of power-gated DFX logic, power-gated DFX logic can be applied to all partitions of a semiconductor chip. The voltage rail 115 VNNAON is an always ON voltage rail during device power on. The DFX power domains 110 include a power gate 120 and DFX logic units 125. Power gates 120 include switches that can turn off the DFX logic units 125. In some examples, power gates 120 include switches that can turn off the DFX logic units 125 completely. Partitions 105, 106, and 107 of the semiconductor chip design 100 can also include functional logic units 130 and power gates 121. Not all functional logic units 130 necessarily include power gates 121. Functional logic units 130 can, for example, perform logic operations and/or logic computation. Functional logic units 130 can be IP logic blocks and DFX logic units 125 can be IP logic blocks for DFX. DFX logic units 125 can be used to debug functional logic units 130 that are, for example, both co-located within a design partition 105, 106, or 107.

Functional logic unit 125 power-gated domains can include INF_ST and INF_VNN. INF_ST is a gated power domain that will be brought-up/ON very early in the power-up boot sequence (ST indicates sustain). The INF_VNN is a normal gated power domain that can house the majority of the functional logic in the semiconductor chip. INF_VNN will typically be brought up much later in a system boot sequence, and will also typically be gated OFF when the system goes into a power saving mode.

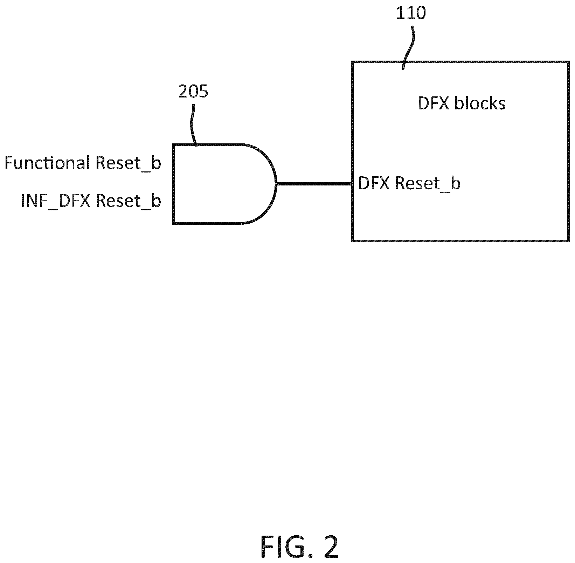

DFX power-gated domains 110 also include reset control logic. Reset control logic can include a functional reset and a DFX power-gated domain reset. Figure 2 illustrates a reset qualifier 205 for the DFX power domains 110 of Figure 1. The reset qualifier 205 includes a functional reset (Functional Reset_b) and a DFX power-gated domain reset (INF_DFX Reset_b) that provide reset for the DFX logic units 125 of the DFX power domains 110 by resetting a state of the DFX logic units 125. Typically, logic block design includes a functional reset control. When a logic block enters reset state, all the flip-flops are held in default state/value. When a logic block is put into INF_DFX power domain (110), the reset is qualified with INF_DFX reset because when the INF_DFX power domain is OFF, the logic block will also need to be brought into reset state. The reset control logic allows the debug mode on a semiconductor chip to be turned ON and OFF dynamically without causing functional failure due, for example, to X propagation (where an unknown value propagates into further logic creating additional unknowns). A debug mode can be turned ON from any functional operating state. Additionally, the reset control logic allows the debug mode on a semiconductor chip to be turned ON and OFF multiple times while the semiconductor chip is operational. The reset qualifier 205 resets DFX logic units 125 when the associated DFX power domains 110 is turned OFF.

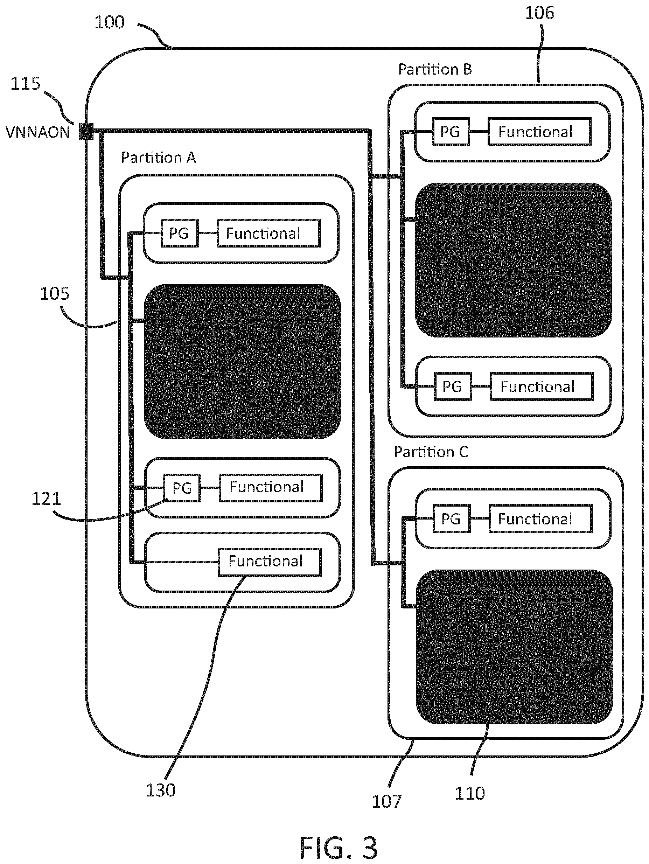

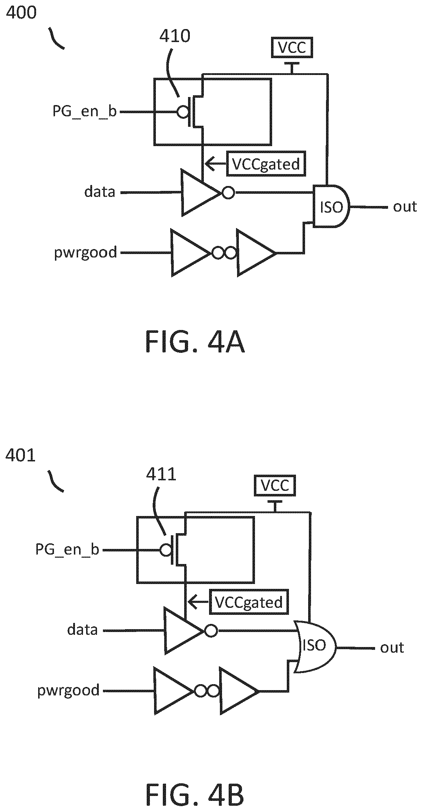

Figure 3 illustrates the semiconductor chip design 100 in an operational state where the DFX power domains 110 are turned OFF (shown as black). The operational state can be one where an end user is operating the computer system. DFX logic can be invisible to the end user. DFX logic typically is used by manufacturers to test and/or debug functional logic. In Figure 4, where elements have the same numbers as in Figure 1, the descriptions herein for those elements can be used for the same-numbered elements in Figure 4. In Figure 4, all of the DFX power domains 110 are shown in the OFF state. During operation of the semiconductor chip, an error or fault can occur in in a design partition 105, 106, and/or 107 and an associated DFX power domain 110 can be turned ON to perform testing and/or debug while the error or fault is present in the design partition 105, 106, and/or 107.

Unified Power Format (UPF) (Institute of Electrical and Electronics Engineers (IEEE) standard (current release date 2018)) is an important design tool for managing power and control in a semiconductor chip design. A Cluster DFX Unit (CDU) is a design hierarchy within a physical design partition that contains most of the DFX logic such as Test-Access Port (TAP), Visualization of Internal Signal Architecture (VISA), and/or DFT scan. DFT scan is a technique that can facilitate the testing and debugging of integrated circuits (ICs). DFT scan involves modifying the circuit design by adding extra logic to enable the capture and output of internal states for testing purpose. For DFX power domains 110, the output ports can be power isolated since DFX power domains 110 are independent relative to all other power domains. When a power domain is down (e.g., LESS ON), it can propagate X (an unknown state) to the logic in a MORE ON power domain. In order to prevent propagation of unknown states from powered down DFX logic, an AND gate circuit or an OR gate circuit can be inserted as a power isolation solution. This power isolation solution can prevent X propagation when the DFX logic unit is powered down. An AND gate, such as that shown in Figure 4A, can force the DFX logic unit output to 0 (i.e., CLAMP to 0) on power down. An OR gate, such as that shown in Figure 4B, can force DFX logic unit output to 1 (i.e., CLAMP to 1).

In Figure 4A an AND gate for CLAMP 0 isolation 400 includes power gate 410. Figure 4B provides an OR gate for CLAMP 1 isolation 401 that includes power gate 411. DFX power domains 110 according to Figure 1 and as described herein can include AND gates or OR gates that prevent the propagation of unknown states from the powered down DFX logic. The power gate 410 "PG_en_b" is isolation enabled, and the prevention of unknown state propagation is enabled. This power gate can be controlled by a power management unit based on the BIOS setting. DFX power domains 110 according to Figure 1 and as described herein can have output ports where the power is isolated with an isolation clamp value that is controlled. The control/override register can be set to a default value (e.g., 1 or 0).

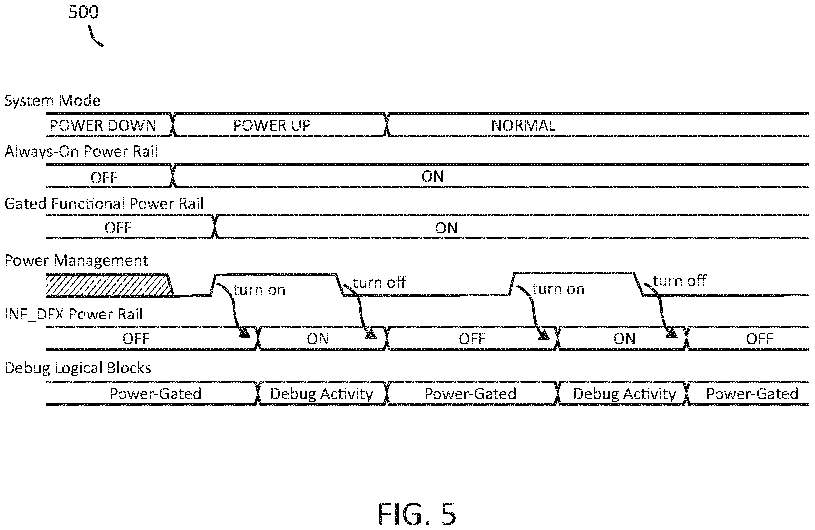

Figure 5 shows a timing diagram 500 for INF_DFX power rail operation for several system modes. On system power up, the always-on power rail is ON. The gated functional power rail is turned ON when the functional logic units (such as functional logic units 130) are in use. The DFX logic units are power gated (OFF) when the debug system is not in operation, for example, when an end-user is operating the system. Gating the DFX logic units can provide power savings. The INF_DFX power rail is turned ON to perform silicon debug operations. Alternatively, the INF_DFX power rail can be turned on by default during semiconductor chip power-up, with the power management unit (retained ON or turned OFF) based on the setting in BIOS (Basic Input/Output System) and/or TAP override. The power management unit (PMU) can be a general system PMU. The INF_DFX rail can be default ON, if BIOS does not enter debug mode, INF_DFX can be turned OFF by the PMU. When BIOS is not in Debug Mode, INF_DFX can be turned-off. When the BIOS / TAP override is set to enter Debug Mode, the INF_DFX power rail can be brought up again.

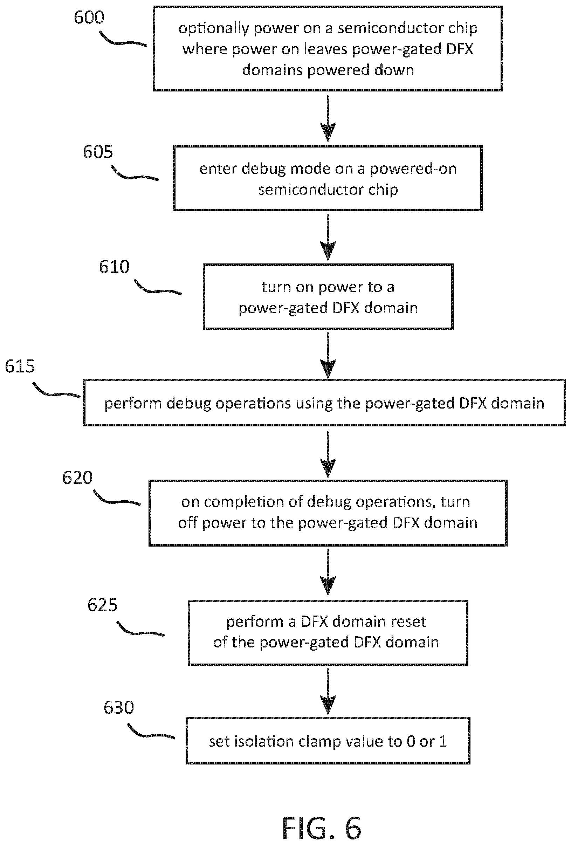

Figure 6 diagrams a method for entering debug mode for a semiconductor chip that is operably connected, for example, to a circuit board or test system that can provide I/O and power. The semiconductor chip can be one as shown in and described with respect to Figures 1 - 3, 4A - 4B, and/or 5. On power-on for the semiconductor chip, the power-gated DFX domains optionally remain powered down 600. The status of the DFX domains (power ON or power OFF) can be a BIOS-controlled setting. The BIOS can include a debug ON/OFF setting. The method includes entering debug mode in a powered-on semiconductor chip 605. A debug mode can be a BIOS setting that enables and brings alive the DFX logic units to help the system debug. Entering debug mode can be through a test access port override event. When a product is placed in a debug mode, additional access privileges that are not available a standard operating mode (for example, a production system owned by an end user) become available. There can be debug registers that expose read-write access to internal states of a system that are not visible in a production mode. On entering debug mode, power is turned on to power-gated DFX domains 610. The power-on sequence can involve the power management unit supplying power to the DFX power rail. Debug operations are performed on the semiconductor chip 615 using the powered-on DFX logic units. After the debug logic units are no longer needed and on exit of the debug mode, power is turned OFF to the power-gated DFX domains 620. The exit event can come from a Joint Test Action Group (JTAG) TAP bit override. A platform reset can also trigger the exit of debug mode. A functional reset and a DFX domain reset can be performed 625. When the exit of the debug mode comes from JTAG TAP bit override, the INF_DFX will reset. For a platform reset, both the functional reset and the INF_DFX reset will occur. The reset can be accomplished with a reset qualifier, such as, for example, that shown and described with respect to Figure 2. An isolation clamp value for the DFX domain is set to 0 or 1, 630. A control/override register can be set to a default value (0 or 1). Entering debug mode with DFX logic unit power-up can be done dynamically and multiple times while a semiconductor chip is powered ON.

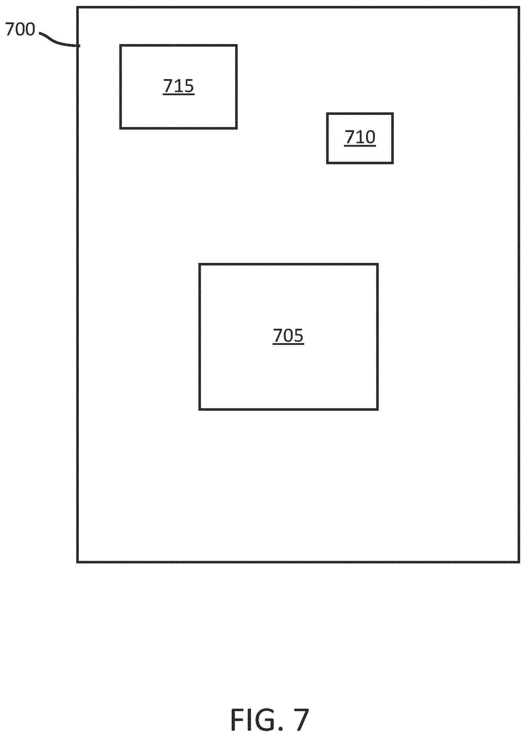

Figure 7 illustrates an exemplary circuit board 700. The circuit board 700 of Figure 7 is a simplified illustration and an actual circuit board can have numerous other features. The circuit board can be a mother board, a system board, a mainboard, a logic board, or a printed circuit board. The circuit board 700 houses and operably connects a semiconductor chip 705 with a BIOS chip 710, a power supply 715. The operable connection provides power to the BIOS chip 710 and the semiconductor chip 705 and I/O between the BIOS chip 710 and the semiconductor chip 705. The circuit board 700 can also include other semiconductor chips as described herein, such as memory, for example, DRAM (not shown).

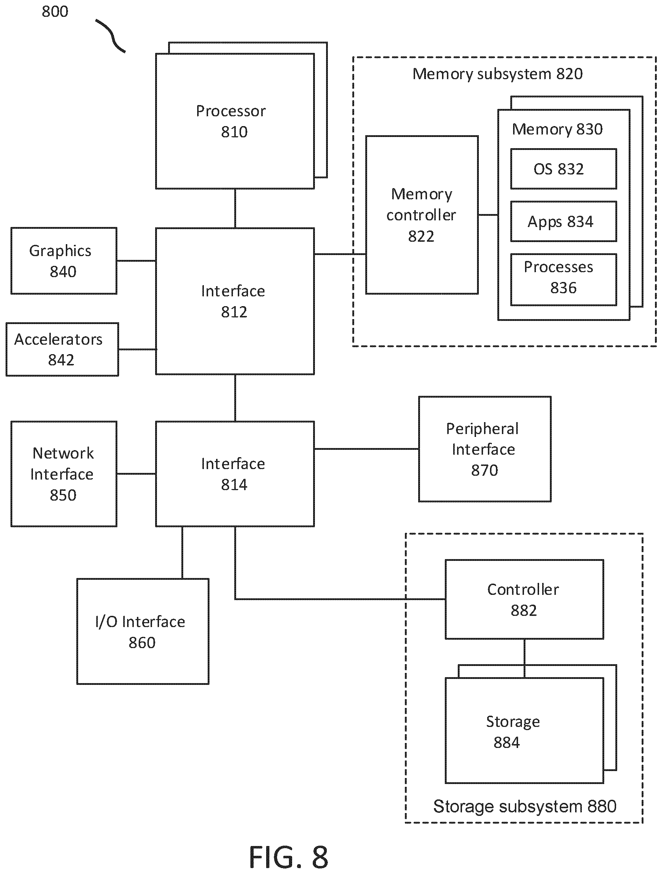

The semiconductor chips described herein can be, for example, any combination of microprocessors, CPUs (central processing units), GPUs (graphics processing units), processing cores, system on a chips (SoCs), other processing hardware, a combination of processors or processing cores, programmable general-purpose or special-purpose microprocessors, accelerators, DSPs, I/O management, programmable controllers, ASICs, programmable logic devices (PLDs), high bandwidth memory (HBM), and/or other memory devices. The semiconductor chips can be any of the chips, for example, described herein with respect to Figure 8. The semiconductor chip can be one that comprises IP logic units, including IP logic units for DFX.

Figure 8 depicts an example computing system in which semiconductor chips comprising power-gated DFX logic as described herein with respect to Figures 1 - 3, 4A- 4B, and/or 5 can be employed. The method described in and with respect to Figure 6 can also be employed for one or more of the elements of the computing system of Figure 8. A computing system 800 can include more, different, or fewer features than the ones described herein with respect to Figure 8.

Computing system 800 includes processor 810, which provides processing, operation management, and execution of instructions for system 800. Processor 810 can include any type of microprocessor, CPU (central processing unit), GPU (graphics processing unit), processing core, or other processing hardware to provide processing for system 800, or a combination of processors or processing cores. Processor 810 controls the overall operation of system 800, and can be or include, one or more programmable general-purpose or special-purpose microprocessors, DSPs, programmable controllers, ASICs, programmable logic devices (PLDs), or the like, or a combination of such devices.

In one example, system 800 includes interface 812 coupled to processor 810, which can represent a higher speed interface or a high throughput interface for system components needing higher bandwidth connections, such as memory subsystem 820 or graphics interface components 840, and/or accelerators 842. Interface 812 represents an interface circuit, which can be a standalone component or integrated onto a processor die. Where present, graphics interface 840 interfaces to graphics components for providing a visual display to a user of system 800. In one example, the display can include a touchscreen display.

Accelerators 842 can be a fixed function or programmable offload engine that can be accessed or used by a processor 810. For example, an accelerator among accelerators 842 can provide data compression (DC) capability, cryptography services such as public key encryption (PKE), cipher, hash/authentication capabilities, decryption, or other capabilities or services. In some cases, accelerators 842 can be integrated into a CPU socket (e.g., a connector to a motherboard (or circuit board, printed circuit board, mainboard, system board, or logic board) that includes a CPU and provides an electrical interface with the CPU). For example, accelerators 842 can include a single or multi-core processor, graphics processing unit, logical execution unit single or multi-level cache, functional units usable to independently execute programs or threads, application specific integrated circuits (ASICs), neural network processors (NNPs), programmable control logic, and programmable processing elements such as field programmable gate arrays (FPGAs) or programmable logic devices (PLDs). Accelerators 842 can provide multiple neural networks, CPUs, processor cores, general purpose graphics processing units, or graphics processing units can be made available for use by artificial intelligence (Al) or machine learning (ML) models.

Memory subsystem 820 represents the main memory of system 800 and provides storage for code to be executed by processor 810, or data values to be used in executing a routine. Memory subsystem 820 can include one or more memory devices 830 such as read-only memory (ROM), flash memory, one or more varieties of random access memory (RAM) such as static RAM (SRAM), dynamic RAM (DRAM), synchronous DRAM (SDRAM) and/or or other memory devices, or a combination of such devices. Memory 830 stores and hosts, among other things, operating system (OS) 832 that provides a software platform for execution of instructions in system 800, and stores and hosts applications 834 and processes 836. In one example, memory subsystem 820 includes memory controller 822, which is a memory controller to generate and issue commands to memory 830. The memory controller 822 can be a physical part of processor 810 or a physical part of interface 812. For example, memory controller 822 can be an integrated memory controller, integrated onto a circuit within processor 810.

System 800 can also optionally include one or more buses or bus systems between devices, such memory buses, graphics buses, and/or interface buses. Buses or other signal lines can communicatively or electrically couple components together, or both communicatively and electrically couple the components. Buses can include physical communication lines, point-to-point connections, bridges, adapters, controllers, or other circuitry or a combination. Buses can include, for example, one or more of a system bus, a peripheral component interface (PCI) or PCI express (PCIe) bus, a Hyper Transport or industry standard architecture (ISA) bus, a small computer system interface (SCSI) bus, a universal serial bus (USB), or a Firewire bus.

In one example, system 800 includes interface 814, which can be coupled to interface 812. In one example, interface 814 represents an interface circuit, which can include standalone components and integrated circuitry. In one example, user interface components or peripheral components, or both, couple to interface 814. Network interface 850 provides system 800 the ability to communicate with remote devices (e.g., servers or other computing devices) over one or more networks. Network interface 850 can include an Ethernet adapter, wireless interconnection components, cellular network interconnection components, USB, or other wired or wireless standards-based or proprietary interfaces. Network interface 850 can transmit data to a device that is in the same data center or rack or a remote device, which can include sending data stored in memory.

Some examples of network interface 850 are part of an infrastructure processing unit (IPU) or data processing unit (DPU), or used by an IPU or DPU. An xPU can refer at least to an IPU, DPU, GPU, GPGPU (general purpose computing on graphics processing units), or other processing units (e.g., accelerator devices). An IPU or DPU can include a network interface with one or more programmable pipelines or fixed function processors to perform offload of operations that can have been performed by a CPU. The IPU or DPU can include one or more memory devices.

In one example, system 800 includes one or more input/output (I/O) interface(s) 860. I/O interface 860 can include one or more interface components through which a user interacts with system 800 (e.g., audio, alphanumeric, tactile/touch, or other interfacing). Peripheral interface 870 can include additional types of hardware interfaces, such as, for example, interfaces to semiconductor fabrication equipment and/or electrostatic charge management devices.

In one example, system 800 includes storage subsystem 880. Storage subsystem 880 includes storage device(s) 884, which can be or include any conventional medium for storing data in a nonvolatile manner, such as one or more magnetic, solid state, and/or optical based disks. Storage 884 can be generically considered to be a "memory," although memory 830 is typically the executing or operating memory to provide instructions to processor 810. Whereas storage 884 is nonvolatile, memory 830 can include volatile memory (e.g., the value or state of the data is indeterminate if power is interrupted to system 800). In one example, storage subsystem 880 includes controller 882 to interface with storage 884. In one example controller 882 is a physical part of interface 812 or processor 810 or can include circuits or logic in both processor 810 and interface 814.

A power source (not depicted) provides power to the components of system 800. More specifically, power source typically interfaces to one or multiple power supplies in system 800 to provide power to the components of system 800.

Exemplary systems may be implemented in various types of computing, smart phones, tablets, personal computers, and networking equipment, such as switches, routers, racks, and blade servers such as those employed in a data center and/or server farm environment.

### EXAMPLES

A semiconductor device can comprise: a first power domain comprising functional logic units; and a second power domain comprising design for test and design for debug (DFX) logic units, wherein the second power domain includes a power gate, wherein the DFX logic units of the second power domain are capable of debugging an operation of the first power domain, wherein the power gate is capable of turning on or turning off power to the DFX logic units, and wherein the power gate comprises a reset qualifier that is capable of resetting the functional logic units. The reset qualifier can be capable of a functional reset and a DFX reset. An output port for the DFX logic units can be power-isolated. The DFX logic units can be intellectual property cores. There can be a plurality of first power domains and a plurality of second power domains. The DFX logic units can include a Test-Access Port (TAP) logic unit, a Visualization of Internal Signal Architecture (VISA) logic unit, a design for test scan logic unit, or a combination thereof. The semiconductor device can be a microprocessor, a central processing unit, a graphics processing unit, or a system on a chip.

A method for debugging a semiconductor device can comprise: entering a debug mode on a semiconductor device; turning power on to a power-gated domain comprising design for test and design for debug (DFX) logic; performing debug operations using the DFX logic; turning power off to the DFX logic; and performing a functional reset of the DFX logic. The method can also include performing a DFX reset of the power-gated domain that comprises the DFX logic. The power-gated domain that comprises the DFX logic can also comprise a reset qualifier which performs the functional reset of the DFX logic. Entering debug mode can be controlled by a basic input/output system (BIOS) setting. The method can also include setting an isolation clamp value to 0 or 1. The DFX logic can include Test-Access Port (TAP) logic, Visualization of Internal Signal Architecture (VISA) logic, design for test scan logic, or a combination thereof.

A computing system can comprise: a circuit board; a basic input/output system (BIOS) chip operably connected to the circuit board; a power supply operably connected to the circuit board; and a semiconductor device operably connected to the circuit board, wherein the semiconductor device comprises: a first power domain comprising functional logic units; and a second power domain comprising design for test and design for debug (DFX) logic units, wherein the second power domain includes a power gate, wherein the DFX logic of the second power domain is capable of debugging an operation of the first power domain, wherein the power gate is capable of turning on or turning off power to the DFX logic units, and wherein the power gate comprises a reset qualifier that is capable of resetting the functional logic units. The BIOS chip can include settings for entering a debug mode on the semiconductor device. The reset qualifier can be capable of a functional reset and a DFX reset. There can be a plurality of first power domains and a plurality of second power domains. The DFX logic units can be intellectual property cores. The DFX logic units can include Test-Access Port (TAP) logic units, Visualization of Internal Signal Architecture (VISA) logic units, design for test scan logic units, or a combination thereof. The semiconductor device can be a microprocessor, a central processing unit, a graphics processing unit, or a system on a chip.

Besides what is described herein, various modifications can be made to what is disclosed and implementations of the invention without departing from their scope. Therefore, the illustrations and examples herein should be construed in an illustrative, and not a restrictive sense. The scope of the invention should be measured solely by reference to the claims that follow.

## Claims

1. A semiconductor device comprising:
a first power domain comprising functional logic units; and
a second power domain comprising design for test and design for debug (DFX) logic units, wherein the second power domain includes a power gate, wherein the DFX logic units of the second power domain are capable of debugging an operation of the first power domain, wherein the power gate is capable of turning on or turning off power to the DFX logic units, and wherein the power gate comprises a reset qualifier that is capable of resetting the functional logic units.

2. The semiconductor device of claim 1, wherein the reset qualifier is capable of a functional reset and a DFX reset.

3. The semiconductor device of claim 1 wherein an output port for the DFX logic units is power-isolated.

4. The semiconductor device of claim 1 wherein there are a plurality of first power domains and a plurality of second power domains.

5. The semiconductor device of claim 1 wherein the DFX logic units include a Test-Access Port (TAP) logic unit, a Visualization of Internal Signal Architecture (VISA) logic unit, a design for test scan logic unit, or a combination thereof.

6. The semiconductor device of any of claims 1-5, wherein the semiconductor device is a microprocessor, a central processing unit, a graphics processing unit, or a system on a chip.

7. A method for debugging a semiconductor device comprising:
entering a debug mode on a semiconductor device;
turning power on to a power-gated domain comprising design for test and design for debug (DFX) logic;
performing debug operations using the DFX logic;
turning power off to the DFX logic; and
performing a functional reset of the DFX logic.

8. The method of claim 7, also including performing a DFX reset of the power-gated domain that comprises the DFX logic.

9. The method of claim 7, wherein the power-gated domain that comprises the DFX logic also comprises a reset qualifier which performs the functional reset of the DFX logic.

10. The method of claim 7, wherein entering debug mode is controlled by a basic input/output system (BIOS) setting.

11. The method of claim 7, also including setting an isolation clamp value to 0 or 1.

12. The method of any of claims 7-11, wherein the DFX logic includes Test-Access Port (TAP) logic, Visualization of Internal Signal Architecture (VISA) logic, design for test scan logic, or a combination thereof.

13. A computing system comprising:
a circuit board;
a basic input/output system (BIOS) chip operably connected to the circuit board;
a power supply operably connected to the circuit board; and
a semiconductor device operably connected to the circuit board, wherein the semiconductor device comprises:
a first power domain comprising functional logic units; and
a second power domain comprising design for test and design for debug (DFX) logic units, wherein the second power domain includes a power gate, wherein the DFX logic of the second power domain is capable of debugging an operation of the first power domain, wherein the power gate is capable of turning on or turning off power to the DFX logic units, and wherein the power gate comprises a reset qualifier that is capable of resetting the functional logic units;
and wherein the BIOS chip includes settings for entering a debug mode on the semiconductor device.

14. The computing system of claim 13, wherein the reset qualifier is capable of a functional reset and a DFX reset.

15. The computing system of claim 13, wherein the DFX logic units include Test-Access Port (TAP) logic units, Visualization of Internal Signal Architecture (VISA) logic units, design for test scan logic units, or a combination thereof.
